# EUROPEAN PATENT APPLICATION

(11) **EP 2 418 699 A2**
(43) Date of publication of application: **15.02.2012**
(21) Application number: 11175277.0
(22) Date of filing: 26.07.2011
(51) Int. Cl.: H01L 33/38

(54) **Electrode configuration for a light emitting diode**

(30) Priority: 12.08.2010 US 855316
(71) Applicant: Chi Mei Lighting Technology Corp., Xinshi Dist., Tainan City 741 (CN)
(72) Inventor: Yu, Kuo-Hui, 741 Tainan City (TW); Wang, Chien-Chun, 741 Tainan City (TW); Chu, Chang-Hsin, 741 Tainan City (TW)
(74) Representative: Becker Kurig Straus

(57) **Abstract**

In one aspect of the invention, a light emitting device includes a substrate (110), and a multilayered structure (120) having an n-type semiconductor layer (122) formed in a light emitting region and a non-emission region on the substrate, an active layer (124) formed in the light emitting region on the n-type semiconductor layer, and a p-type semiconductor layer (126) formed in the light emitting region on the active layer. The light emitting device also includes a p-electrode (132) formed in the light emitting region and electrically coupled to the p-type semiconductor layer, and an n-electrode (140,141,142,143) formed in the non-emission region and electrically coupled to the n-type semiconductor layer. Further, the light emitting device also includes an insulator (150) formed between the n-electrode and the n-type semiconductor layer in the first portion of the non-emission region to define at least one ohmic contact such that the n-electrode in the first portion of the non-emission region is electrically coupled to the n-type semiconductor layer through the at least one ohmic contact.

## Description

### CROSS-REFERENCE TO RELATED PATENT APPLICATION

Some references, which may include patents, patent applications and various publications, are cited and discussed in the description of this invention. The citation and/or discussion of such references is provided merely to clarify the description of the present invention and is not an admission that any such reference is "prior art" to the invention described herein. All references cited and discussed in this specification are incorporated herein by reference in their entireties and to the same extent as if each reference were individually incorporated by reference.

### FIELD OF THE INVENTION

The present invention relates generally to a light emitting device, and more particular to a light emitting device that utilizes an insulator and/or an epitaxial structure formed under the n-electrode to improve the uniformity in the current density of the light emitting device.

### BACKGROUND OF THE INVENTION

Light emitting diodes (LEDs) have been widespread used for lighting with great brightness. Typically, an LED includes a multilayered structure of semiconductors, p- and n-electrodes and their connection pads placed on the surfaces of the multilayered structure. In operation, a current is injected into the LED through external terminals that are connected to the connection pads. The injected current from the p- and n-electrodes spreads into the respective semiconductor layers. Light is generated when the current flows across the p-n junction in the forward direction which causes the recombination of minority carriers at the p-n junction. The intensity of the light emitted by the LED under typical operating conditions is proportional to the current density. For a given current density, the larger the area of the p-n junction is, the greater the intensity generated by the LED.

Traditionally, for an LED to output much brighter light, it is implemented by maximizing the light emitting region of the LED so as to promote the flowing direction of the operation current of the LED. For a large scaled LED operated with a large current, if the distribution of the current density in the light emitting region of the LED is non-uniform, it causes the forward voltage and the temperature at interfaces to increase, which leads a reduction in the optical and electrical performance of the LED, particularly for the LED with larger dimensions and operated in conditions of a high current density. In addition, as the irreversible degradation in efficiency of light emission increases with increasing the current density, the non-uniformity in the current density increases the overall rate of degradation, thereby, reducing the lifetime of the LED.

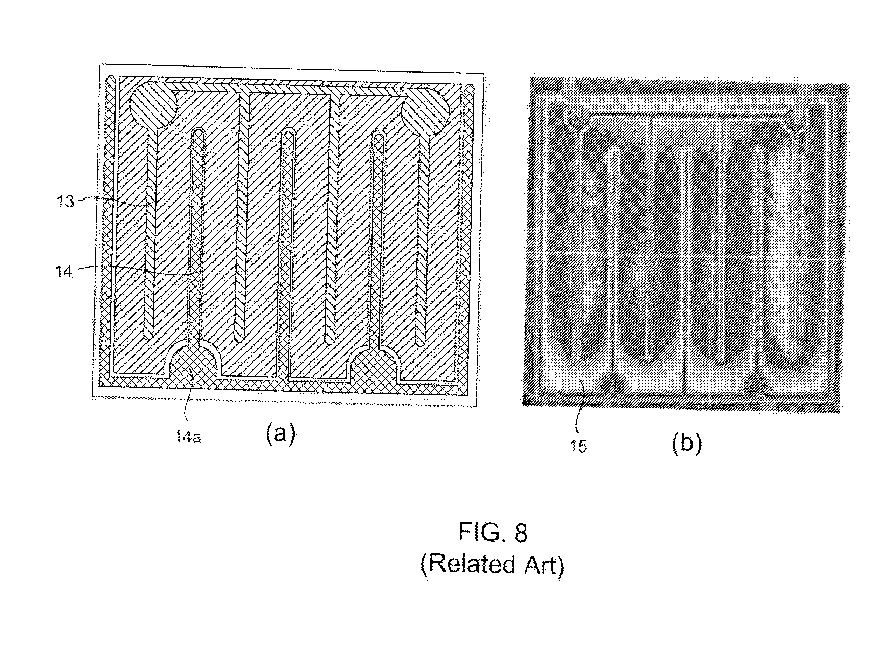

U.S. Patent No. 6,307,218 to Steigerwald et al. discloses an LED design that utilizes paralleled p-electrodes and n-electrodes, as shown in FIG. 8A, to improve the non-uniformity in the current density of the LED. In Steigerwald et al, the current flowing vertically down to the n-type semiconductor layer from the area of the p-electrode finger 13 distal to the n-connection pad 14a has to traverse a current flowing path in the n-type semiconductor layer to reach the n-electrode finger 14 once it has passed vertically through the p-n junction, however, the current flowing path is different from the traverse distance in the n-type semiconductor layer while current flowing vertically down to the n-type semiconductor layer from the area of the p-electrode finger 13 next to the n-connection pad 14a to reach the n-electrode 14a. The differences in the current paths result in uneven distribution of current around the n-connection pad 14a. Accordingly, the light brightness (intensity) of the LED in an area 15 proximate to an end portion of the n-electrode 14 is uneven than that in the other light emitting area, as shown in FIG. 8B. The non-uniformity in the light brightness is caused by the non-uniformity in the current density of the LED therein.

Therefore, a heretofore unaddressed need exists in the art to address the aforementioned deficiencies and inadequacies.

### SUMMARY OF THE INVENTION

In one aspect, the present invention relates to a light emitting device. In one embodiment, the light emitting device includes a substrate, and a multilayered structure having a first end portion and an opposite, second end portion defining a light emitting region and a non-emission region therebetween, the non-emission region having a first portion located next to the first end portion and a second portion extending from the first portion into the light emitting region. The multilayered structure includes an n-type semiconductor layer formed in the light emitting region and the non-emission region on the substrate, an active layer formed in the light emitting region on the n-type semiconductor layer, and a p-type semiconductor layer formed in the light emitting region on the active layer.

The light emitting device also includes a p-electrode formed in the light emitting region and electrically coupled to the p-type semiconductor layer, and an n-electrode formed in the non-emission region and electrically coupled to the n-type semiconductor layer.

Further, the light emitting device also includes an insulator formed between the n-electrode and the n-type semiconductor layer in the first portion of the non-emission region to define at least one ohmic contact such that the n-electrode in the first portion of the non-emission region is electrically coupled to the n-type semiconductor layer through the at least one ohmic contact.

The light emitting device further has a transparent, conductive layer formed on the p-type semiconductor layer in the light emitting region such that the p-electrode is electrically coupled to the p-type semiconductor layer through the transparent conductive layer.

In one embodiment, the insulator has at least one layer. The insulator is formed of a single material or a compound of multiple materials. In one embodiment, the insulator is formed of at least one of transparent oxides and nitrides, where the insulator is formed of SiO₂, SiN, Al₂O₃, TiO₂, or a combination thereof. The insulator may include an epitaxial structure.

In one embodiment, the n-electrode has an n-electrode bridge formed on the insulator in the first portion of the non-emission region, and a plurality of n-electrode fingers parallelly formed on the n-type semiconductor layer in the second portion of the non-emission region. Each n-electrode finger has a first end electrically connected to the n-electrode bridge and an opposite, second end extending to the light emitting region of the multilayered structure. The p-electrode has a p-electrode bridge formed proximate to the second end portion of the multilayered structure and a plurality of p-electrode fingers parallelly positioned in the light emitting region. Each p-electrode finger has a first end electrically connected to the p-electrode bridge, and an opposite, second end extending to the first end portion of the multilayered structure and substantially proximate to the n-electrode bridge. The plurality of p-electrode fingers and the plurality of n-electrode fingers are alternately arranged.

In one embodiment, the n-electrode bridge includes at least one wire connection pad electrically connected to a corresponding n-electrode finger and positioned over the at least one ohmic contact such that the at least one wire connection pad is electrically connected to the n-type semiconductor layer through at the at least one ohmic contact. As such, in operation, a current flowing path between the corresponding n-electrode finger and one adjacent p-electrode finger is substantially same as that between the at least one ohmic contact under the at least one wire connection pad and the adjacent p-electrode finger.

In one embodiment, each of the n-electrode and the p-electrode is formed of a transparent, conductive material. The n-electrode is electrically insulated from the p-electrode, the transparent conductive layer, the p-type semiconductor layer and the active layer.

In another aspect, the present invention relates to a method of manufacturing a light emitting device. In one embodiment, the method includes the steps of providing a substrate and forming a multilayered structure on the substrate, where the multilayered structure has an n-type semiconductor layer formed on the substrate, an active layer formed on the n-type semiconductor layer, and a p-type semiconductor layer formed on the active layer. The multilayered structure has a first end portion and an opposite, second end portion defining a light emitting region and a non-emission region therebetween, where the non-emission region has a first portion located next to the first end portion and a second portion extending from the first portion into the light emitting region.

The method also includes the steps of etching off the p-type the semiconductor layer and the active layer of the multilayered structure in the non-emission region so as to expose the n-type semiconductor layer therein, and forming an insulator in the first portion of the non-emission region on the exposed n-type semiconductor layer, the insulator defining at least one at least one ohmic contact.

Furthermore, the method includes the steps of forming an n-electrode in the non-emission region such that the n-electrode in the first portion of the non-emission region is electrically coupled to the n-type semiconductor layer through the at least one ohmic contact, and the n-electrode in the second portion of the non-emission region is electrically coupled to the n-type semiconductor layer directly, forming a transparent, conductive layer on the p-type semiconductor layer in the light emitting region, and forming a p-electrode on the transparent conductive layer such that the p-efectrode is electrically coupled to the p-type semiconductor layer through the transparent conductive layer.

In one embodiment, the insulator comprises at least one layer. The insulator is formed of at least one of transparent oxides and nitrides. In one embodiment, the insulator is formed of a single material or a compound of multiple materials. In one embodiment, the insulator has an epitaxial structure.

In one embodiment, the n-electrode has an n-electrode bridge formed on the insulator in the first portion of the non-emission region, and a plurality of n-electrode fingers parallelly formed on the n-type semiconductor layer in the second portion of the non-emission region. Each n-electrode finger has a first end electrically connected to the n-electrode bridge and an opposite, second end extending to the light emitting region of the multilayered structure. The p-electrode has a p-electrode bridge formed proximate to the second end portion of the multilayered structure and a plurality of p-electrode fingers parallelly positioned in the light emitting region. Each p-electrode finger has a first end electrically connected to the p-electrode bridge, and an opposite, second end extending to the first end portion of the multilayered structure and substantially proximate to the n-electrode bridge. The plurality of p-electrode fingers and the plurality of n-electrode fingers are alternately arranged.

In one embodiment, the n-electrode bridge includes at least one wire connection pad electrically connected to a corresponding n-electrode finger and positioned over the at least one ohmic contact such that the at least one wire connection pad is electrically connected to the n-type semiconductor layer through at the at least one ohmic contact. As such, in operation, a current flowing path between the corresponding n-electrode finger and one adjacent p-electrode finger is substantially same as that between the at least one ohmic contact under the at least one wire connection pad and the adjacent p-electrode finger.

In yet another aspect, the present invention relates to a light emitting device. In one embodiment, the light emitting device includes a substrate, and a multilayered structure having a first end portion and an opposite, second end portion defining a light emitting region and a non-emission region therebetween, the non-emission region having a first portion located next to the first end portion and a second portion extending from the first portion into the light emitting region. The multilayered structure has an n-type semiconductor layer formed on the substrate, an active layer formed on the n-type semiconductor layer; and a p-type semiconductor layer formed on the active layer.

The multilayered structure is formed to have an epitaxial structure in the first portion of the non-emission region to define at least one ohmic contact therein. In one embodiment, the epitaxial structure comprises at least one layer. The epitaxial structure comprises a p-layer/active layer/n-layer structure. The epitaxial structure is isolated from the active layer and the p-type semiconductor layer.

The light emitting device also includes an n-electrode formed in the non-emission region and electrically coupled to the n-type semiconductor layer, such that the n-electrode in the first portion of the non-emission region is electrically coupled to the n-type semiconductor layer through at the at least one ohmic contact, and a p-electrode formed in the light emitting region and electrically coupled to the p-type semiconductor layer.

The light emitting device may also have a transparent, conductive layer formed on the p-type semiconductor layer in the light emitting region such that the p-electrode is electrically coupled to the p-type semiconductor layer through the transparent conductive layer.

In one embodiment, the n-electrode has an n-electrode bridge formed on the insulator in the first portion of the non-emission region, and a plurality of n-electrode fingers parallelly formed on the n-type semiconductor layer in the second portion of the non-emission region. Each n-electrode finger has a first end electrically connected to the n-electrode bridge and an opposite, second end extending to the light emitting region of the multilayered structure. The p-electrode has a p-electrode bridge formed proximate to the second end portion of the multilayered structure and a plurality of p-electrode fingers parallelly positioned in the light emitting region. Each p-electrode finger has a first end electrically connected to the p-electrode bridge, and an opposite, second end extending to the first end portion of the multilayered structure and substantially proximate to the n-electrode bridge. The plurality of p-electrode fingers and the plurality of n-electrode fingers are alternately arranged.

In one embodiment, the n-electrode bridge includes at least one wire connection pad electrically connected to a corresponding n-electrode finger and positioned over the at least one ohmic contact such that the at least one wire connection pad is electrically connected to the n-type semiconductor layer through at the at least one ohmic contact. As such, in operation, a current flowing path between the corresponding n-electrode finger and one adjacent p-electrode finger is substantially same as that between the at least one ohmic contact under the at least one wire connection pad and the adjacent p-electrode finger.

The n-electrode is electrically insulated from the p-electrode, the transparent conductive layer, the p-type semiconductor layer and the active layer.

In a further aspect, the present invention relates to a method of manufacturing a light emitting device. In one embodiment, the method includes the steps of providing a substrate, and forming a multilayered structure on the substrate, where the multilayered structure has an n-type semiconductor layer formed on the substrate, an active layer formed on the n-type semiconductor layer, and a p-type semiconductor layer formed on the active layer. The multilayered structure has a first end portion and an opposite, second end portion defining a light emitting region and a non-emission region therebetween. The non-emission region has a first portion located next to the first end portion and a second portion extending from the first portion into the light emitting region.

The method also includes the step of etching the multilayered structure in the non-emission region to form an epitaxial structure in the first portion of the non-emission region and expose the n-type semiconductor layer in the second portion of the non-emission region, the epitaxial structure defining at least one ohmic contact therein.

In one embodiment, the epitaxial structure comprises at least one layer. The epitaxial structure comprises a p-layer/active layer/n-layer structure. The epitaxial structure is isolated from the active layer and the p-type semiconductor layer.

The method further includes the step of forming an n-electrode in the non-emission region such that the n-electrode in the first portion of the non-emission region is electrically coupled to the n-type semiconductor layer through the at least one ohmic contact, and the n-electrode in the second portion of the non-emission region is electrically coupled to the n-type semiconductor layer directly, forming a transparent, conductive layer on the p-type semiconductor layer in the light emitting region, and forming a p-electrode on the transparent conductive layer such that the p-electrode is electrically coupled to the p-type semiconductor layer through the transparent conductive layer.

In one embodiment, the n-electrode has an n-electrode bridge formed on the insulator in the first portion of the non-emission region, and a plurality of n-electrode fingers parallelly formed on the n-type semiconductor layer in the second portion of the non-emission region. Each n-electrode finger has a first end electrically connected to the n-electrode bridge and an opposite, second end extending to the light emitting region of the multilayered structure. The p-electrode has a p-electrode bridge formed proximate to the second end portion of the multilayered structure and a plurality of p-electrode fingers parallelly positioned in the light emitting region. Each p-electrode finger has a first end electrically connected to the p-electrode bridge, and an opposite, second end extending to the first end portion of the multilayered structure and substantially proximate to the n-electrode bridge. The plurality of p-electrode fingers and the plurality of n-electrode fingers are alternately arranged.

In one embodiment, the n-electrode bridge includes at least one wire connection pad electrically connected to a corresponding n-electrode finger and positioned over the at least one ohmic contact such that the at least one wire connection pad is electrically connected to the n-type semiconductor layer through at the at least one ohmic contact. As such, in operation, a current flowing path between the corresponding n-electrode finger and one adjacent p-electrode finger is substantially same as that between the at least one ohmic contact under the at least one wire connection pad and the adjacent p-electrode finger.

In yet a further aspect, the present invention relates to a light emitting device. In one embodiment, the light emitting device includes a multilayered structure having a light emitting region and a non-emission region partially extending into the light emitting region, comprising an n-type semiconductor layer, an active layer formed on the n-type semiconductor layer, and a p-type semiconductor layer formed on the active layer, a p-electrode formed in the light emitting region and electrically coupled to the p-type semiconductor layer, and an n-electrode formed in the non-emission region and electrically coupled to the n-type semiconductor layer.

The multilayered structure has a first end portion and an opposite, second end portion such that the light emitting region and the non-emission region are defined therebetween, wherein the non-emission region has a first portion located next to the first end portion and a second portion extending from the first portion into the light emitting region.

The light emitting device also includes an insulator formed between the n-electrode and the n-type semiconductor layer in the non-emission region defining at least one ohmic contact such that the n-electrode is electrically coupled to the n-type semiconductor layer at least through the at least one ohmic contact.

The light emitting device may further comprises a transparent, conductive layer formed on the p-type semiconductor layer in the light emitting region such that the p-electrode is electrically coupled to the p-type semiconductor layer through the transparent conductive layer.

In one embodiment, the multilayered structure is formed such that the n-type semiconductor layer is exposed in the non-emission region, wherein the insulator is formed on the n-type semiconductor layer in the first portion of the non-emission region such that the n-electrode in the first portion of the non-emission region is electrically coupled to the n-type semiconductor layer through the at least one ohmic contact, and wherein the n-electrode in the second portion of the non-emission region is electrically coupled to the n-type semiconductor layer directly.

In one embodiment, the insulator comprises at least one layer. The insulator is formed of a single material or a compound of multiple materials. In one embodiment, the insulator is formed of at least one of transparent oxides and nitrides.

In one embodiment, the insulator includes an epitaxial structure. The epitaxial structure comprises a p-layer/active layer/n-layer structure. The epitaxial structure is isolated from the active layer and the p-type semiconductor layer.

In one embodiment, the n-electrode has an n-electrode bridge formed on the insulator in the first portion of the non-emission region, and a plurality of n-electrode fingers parallelly formed on the n-type semiconductor layer in the second portion of the non-emission region. Each n-electrode finger has a first end electrically connected to the n-electrode bridge and an opposite, second end extending to the light emitting region of the multilayered structure. The p-electrode has a p-electrode bridge formed proximate to the second end portion of the multilayered structure and a plurality of p-electrode fingers parallelly positioned in the light emitting region. Each p-electrode finger has a first end electrically connected to the p-electrode bridge, and an opposite, second end extending to the first end portion of the multilayered structure and substantially proximate to the n-electrode bridge. The plurality of p-electrode fingers and the plurality of n-electrode fingers are alternately arranged.

In one embodiment, the n-electrode bridge includes at least one wire connection pad electrically connected to a corresponding n-electrode finger and positioned over the at least one ohmic contact such that the at least one wire connection pad is electrically connected to the n-type semiconductor layer through at the at least one ohmic contact. As such, in operation, a current flowing path between the corresponding n-electrode finger and one adjacent p-electrode finger is substantially same as that between the at least one ohmic contact under the at least one wire connection pad and the adjacent p-electrode finger.

These and other aspects of the present invention will become apparent from the following description of the preferred embodiment taken in conjunction with the following drawings, although variations and modifications therein may be affected without departing from the spirit and scope of the novel concepts of the disclosure.

### BRIEF DESCRIPTION OF THE DRAWINGS

The accompanying drawings illustrate one or more embodiments of the invention and together with the written description, serve to explain the principles of the invention. Wherever possible, the same reference numbers are used throughout the drawings to refer to the same or like elements of an embodiment, and wherein:
FIG. 1 shows schematically a top view of a light emitting region and a non-emission region of a light emitting device according to one embodiment of the present invention;
FIG. 2 shows schematically another top view of the light emitting region and the non-emission region of the light emitting device as shown in FIG. 1;
FIG. 3 shows schematically a top view of the light emitting device as shown in FIG. 1;
FIG. 4 shows schematically cross sectional views of the light emitting device as shown in F1G. 3, (a) along with the A-A' line and (b) along with the B-B' line;
FIG. 5 shows schematically a fabricating process (a)-(c) of the light emitting device as shown in FIG. 3;
FIG. 6 shows schematically a fabricating process (a) and (b) of a light emitting device according to another embodiment of the present invention;
FIG. 7 shows schematically a light emitting device in operation according to one embodiment of the present invention; and
FIG. 8 shows schematically (a) a top view of a conventional light emitting device and (b) the conventional light emitting device in operation.

### DETAILED DESCRIPTION OF THE INVENTION

The present invention will now be described more fully hereinafter with reference to the accompanying drawings, in which exemplary embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" or "has" and/or "having" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

The term "layer", as used herein, refers to a thin sheet or thin film.

The term "electrode", as used herein, is an electrically conductive layer or film formed of one or more electrically conductive materials.

As used herein, the term "ohmic contact" refers to a region on a semiconductor device that has been prepared so that the current-voltage curve of the device is linear and symmetric.

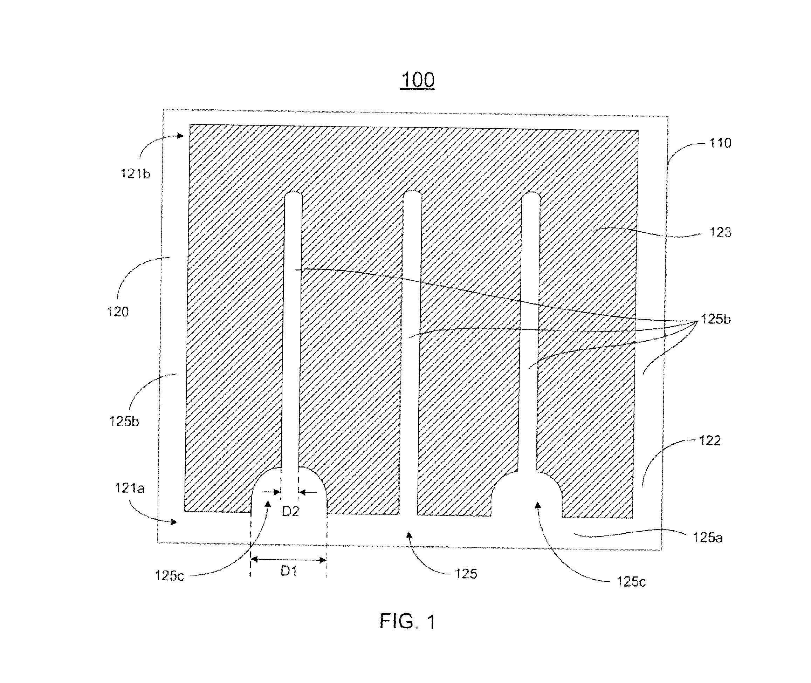

The description will be made as to the embodiments of the present invention in conjunction with the accompanying drawings of FIGS. 1-7. In accordance with the purposes of this invention, as embodied and broadly described herein, this invention, in one aspect, relates to a light emitting device.

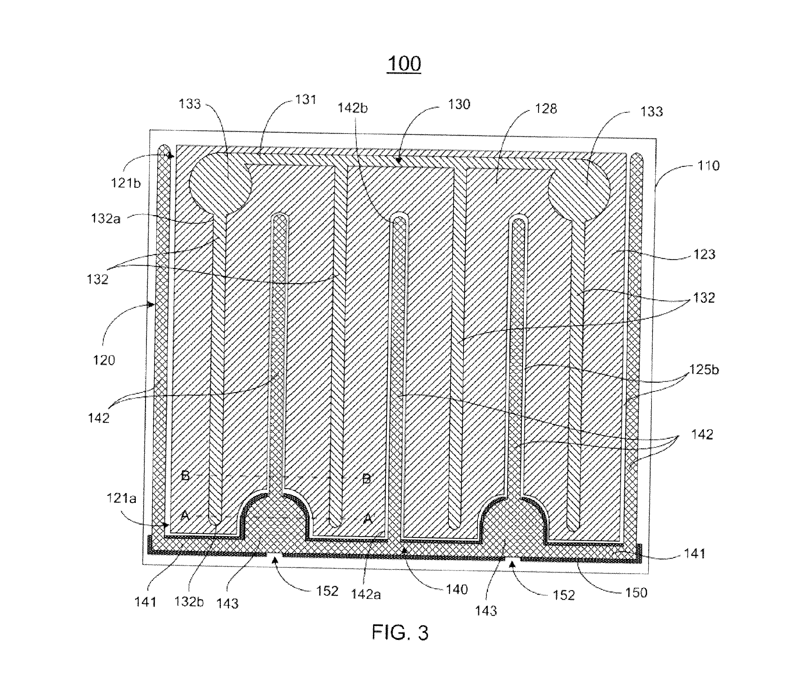

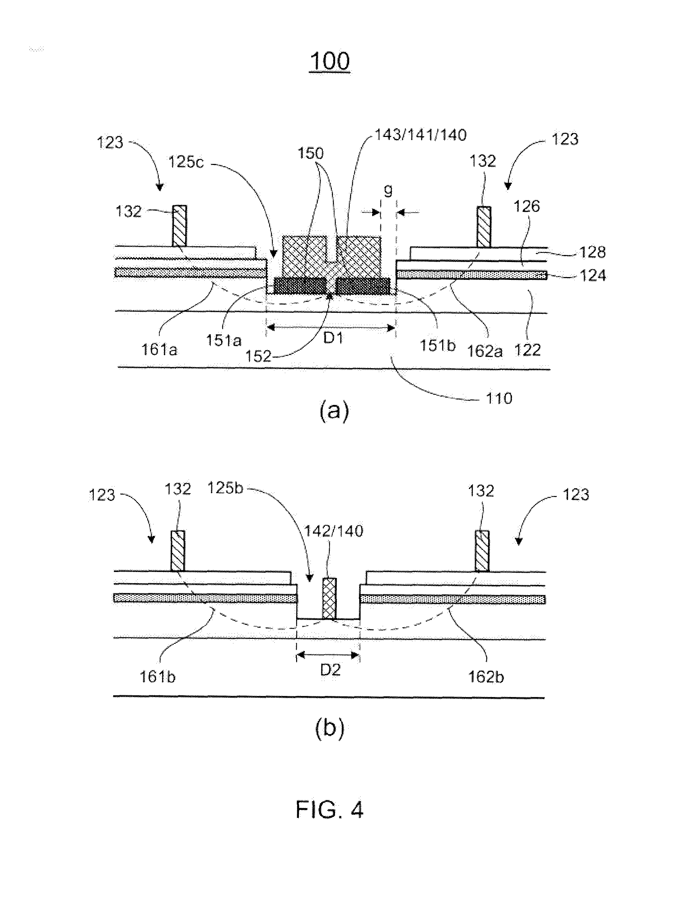

Referring to FIGS. 1-5, and particularly to FIGS. 3 and 4, a light emitting device 100 is shown according to one embodiment of the present invention. In the exemplary embodiment, the light emitting device 100 includes a multilayered structure 120 formed on a substrate 110, a p-electrode 130 and an n-electrode 140 electrically coupled to the multilayered structure 120 for injecting an operative current thereto. The n-electrode 140 and the p-electrode 130 are formed of a conductive material, or different conductive materials.

The multilayered structure 120 has a first end portion 121a and an opposite, second end portion 121b defining a light emitting region 123 and a non-emission region 125 of the light emitting device 100 therebetween. As shown in FIG. 4, the multilayered structure 120 includes an n-type semiconductor layer 122 formed in the light emitting region 123 and the non-emission region 125 on the substrate 110, an active layer 124 formed in the light emitting region 123 on the n-type semiconductor layer 122, and a p-type semiconductor layer 126 formed in the light emitting region 123 on the active layer 124. In one example, the active layer 124 can be an MQW (Multiple Quantum Well) layer. The p-electrode 130 is formed in the light emitting region 123 and electrically coupled to the p-type semiconductor layer 126 through a transparent, conductive layer 128 formed on the p-type semiconductor layer 126. The n-electrode 140 is formed in the non-emission region 125 and electrically coupled to the n-type semiconductor layer 122.

As shown in FIG. 1, the non-emission region 125 is defined in the form of a recess in the multilayered structure 120, such that the n-type semiconductor layer 122 is exposed therein. The non-emission region 125 has a first portion 125a located next to the first end portion 121a of the multilayered structure 120 and a second portion 125b extending from the first portion 125a into the light emitting region 123. In this embodiment, the first portion 125a includes two half-obround shaped recesses 125c, and the second portion 125b includes a plurality of grooves/slots 125b parallelly and spatially formed in the light emitting region 123. Each half-obround shaped recess 125c has a width, D1. Each groove 125b has a width, D2, which is less than D1.

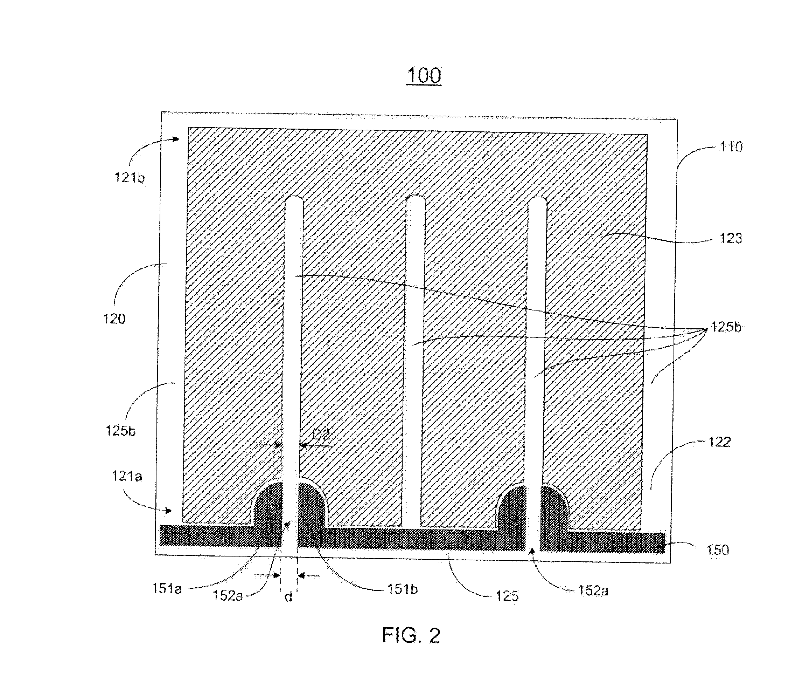

As shown in FIG. 2, an insulator 150 is deposited in the first portion 125a of the non-emission region 125 on the n-type semiconductor layer 122, so as to cover the n-type semiconductor layer 122 in the first portion 125a of the non-emission region 125, except that, over each half-obround shaped recess 125c, the insulator 150 is deposited into two portions 151a and 151b separated by a gap 152a having a width, d, where the n-type semiconductor layer 122 is exposed. The width d of the gap 152a is substantially same as the width D2 of each groove 125b. It is the gap 152a that defines an ohmic contact through which the n-electrode 140 in the first portion of the non-emission region 125 is electrically coupled to the n-type semiconductor layer 122. The insulator 150 includes one or more layers, and is formed of a single material or a compound of multiple materials. In one embodiment, the insulator 150 is formed of at least one of transparent oxides and nitrides. Specifically, the insulator is formed of SiO₂, SiN, Al₂O₃, TiO₂, or the like. The insulator 150 may include an epitaxial structure.

In this embodiment shown in FIGS. 1-5, and particularly in FIG. 3, the n-electrode 140 has an n-electrode bridge 141 formed on the insulator 150 in the first portion 125a of the non-emission region 125, and a plurality of n-electrode fingers 142 parallelly formed on the n-type semiconductor layer 140 in the second portion 125b of the non-emission region 125. Each n-electrode finger 142 has a first end 142a electrically connected to the n-electrode bridge 141 and an opposite, second end 142b extending to the light emitting region 123 of the multilayered structure 120. The n-electrode bridge 141 includes one or more wire connection pads 143 formed on the insulator 150 over the corresponding half-obround shaped recess 125c of the first portion 125a of the non-emission region 125. The wire connection pads 143 are adapted for providing the electrical connection of extra-terminals to the n-electrode 140. Each connection pad 143 is electrically connected to a corresponding n-electrode finger 142 and positioned over the corresponding ohmic contact 152. Accordingly, the wire connection pad 143 is electrically connected to the n-type semiconductor layer 122 through the ohmic contact 152. In addition, the n-electrode 140 in the second portion 125b of the non-emission region 125 is electrically connected to the n-type semiconductor layer 122 directly, since the plurality of n-electrode fingers 142 is parallelly formed on the n-type semiconductor layer 140 in the second portion 125b of the non-emission region 125.

The p-electrode 130 has a p-electrode bridge 131 formed proximate to the second end portion 121 b of the multilayered structure 120 and a plurality of p-electrode fingers 132 parallelly positioned in the light emitting region 123. Each p-electrode finger 132 has a first end 132a electrically connected to the p-electrode bridge 131, and an opposite, second end 132b extending to the first end portion 121a of the multilayered structure 120. According to the invention, the second end 132b of each p-electrode finger 132 is substantially proximate to the n-electrode bridge 141. Further, the p-electrode bridge 131 may have one or more wire connection pads 133 for providing the electrical connection of extra-terminals to the p-electrode 130.

Additionally, the plurality of p-electrode fingers 132 and the plurality of n-electrode fingers 142 are alternately arranged, as shown in FIGS. 3 and 4, such that the injected current is uniformly distributed through out the light emitting device 100.

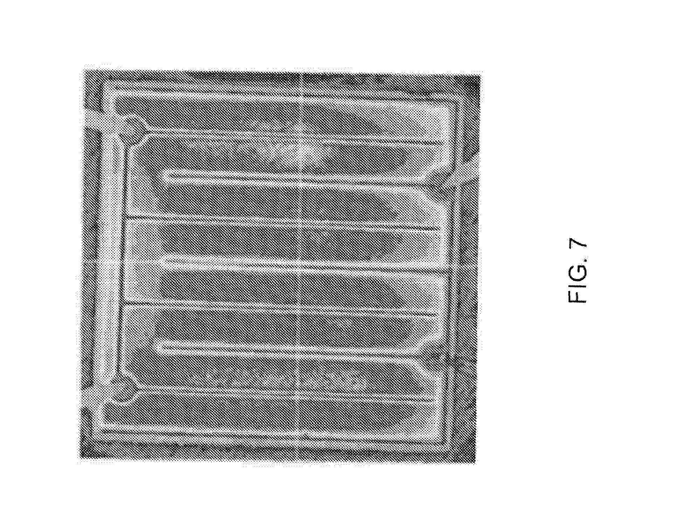

For such a light emitting device 100, when a current is injected at the p-electrode 130, the current flows from the p-electrode fingers 132 along the shortest path (i.e., usually vertically) across the p-n junction to the n-type semiconductor layer 122. The current then spreads laterally within the n-type semiconductor layer 122 to reach the n-electrode 140. Because of the ohmic contact 152 defined on the wire connection pad 143, the current reaching the n-electrode 140 at the area of the wire connection pad 143 is through the ohmic contact 152, which makes the current flowing path 161b (162b) from a p-electrode finger 132 to a corresponding n-electrode finger 142 at the area distal to the wire connection pad 143 substantially same as that 161a (162a) from the p-electrode finger 132 to the corresponding n-electrode 140 at the area of the wire connection pad 143. This results in the uniformity in the current density of the light emitting device 100. Additionally, according to the invention, the ends 132b of the p-electrode fingers 132 of the p-electrode 130 extends into the first end portion 121a of the multilayered structure 120 and substantially close to the n-electrode bridge 141 and the wire connection pad 143 of the n-electrode 140, as shown in FIG. 3, which further improves the uniformity in the current density at least in the peripheral portion of the light emitting device 100. Accordingly, the brightness (intensity) of light emitted from the light emitting device is uniform over the light emitting region of the light emitting device 100, as shown in FIG. 7.

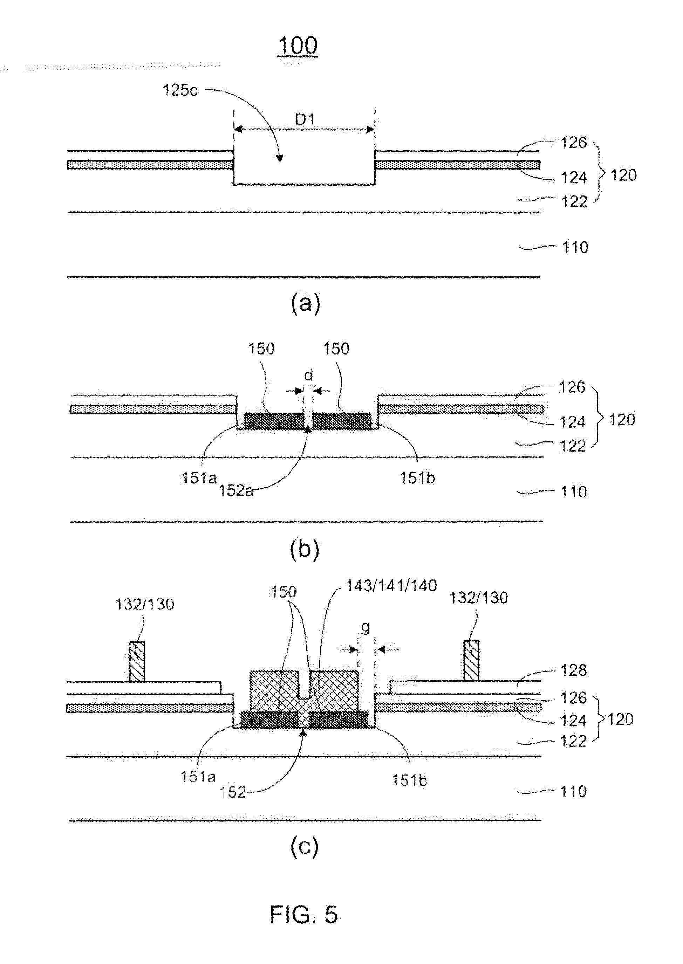

As shown in FIG. 5, the light emitting device 100 can be fabricated according to the following processes.

At first, the multilayered structure 120 is formed on the substrate 110. The multilayered structure 120 includes the n-type semiconductor layer 122 formed on the substrate 110, the active layer 124 formed on the n-type semiconductor layer 122, and the p-type semiconductor layer 126 formed on the active layer 124.

Then, the p-type the semiconductor layer 126 and the active layer 124 of the multilayered structure 120 are etched off at pre-selected locations to expose the n-type semiconductor layer 122 so as to define the non-emission region 125 therein, as shown in FIG. 5a. The remaining area of the multilayered structure 120 is corresponding to the light emitting region 123. The non-emission region 125 is defined to have a first portion 125a located next to the first end portion 121 a of the multilayered structure 120 and a second portion 125b extending from the first portion 125a into the light emitting region 123. The first portion 125a of the non-emission region 125 includes one or more half-obround shaped recesses 125c, and the second portion 125b includes a plurality of grooves/slots 125b parallelly and spatially formed in the light emitting region 123. Each half-obround shaped recess 125c has a width, D1. Each groove 125b has a width, D2, which is less than D1.

The next process is to deposit an insulating material on the exposed n-type semiconductor layer 122 in the first portion 125a of the non-emission region 125 to form the insulator 150, as shown in FIG. 5b. Over each half-obround shaped recess 125c, the insulator 150 is deposited into two portions 151 a and 151b separated by a gap 152a having a width, d, where the n-type semiconductor layer 122 is exposed. The width d of the gap 152a is substantially same as the width D2 of each groove 125b.

The transparent, conductive layer 128 is optionally formed on the p-type semiconductor layer 126 in the light emitting region 123. The n-electrode 140 is then formed in the non-emission region 125 such that the n-electrode 140 in the first portion 125a of the non-emission region 125 is electrically coupled to the n-type semiconductor layer 122 through the ohmic contact 152 defined in the a gap 152a, as shown in FIG. 5c, while the n-electrode 140 in the second portion 125b of the non-emission region 125 is electrically coupled to the n-type semiconductor layer 122 directly. It is the gap 152a that defines an ohmic contact 152 through which the n-electrode 140 in the first portion of the non-emission region 125 is electrically coupled to the n-type semiconductor layer 122.

Finally, the p-electrode 130 is formed on the transparent conductive layer 128 such that the p-electrode 130 is electrically coupled to the p-type semiconductor layer 126 through the transparent conductive layer 128. However, the p-electrode 130 can also be formed together with the n-electrode 140 using the same process steps.

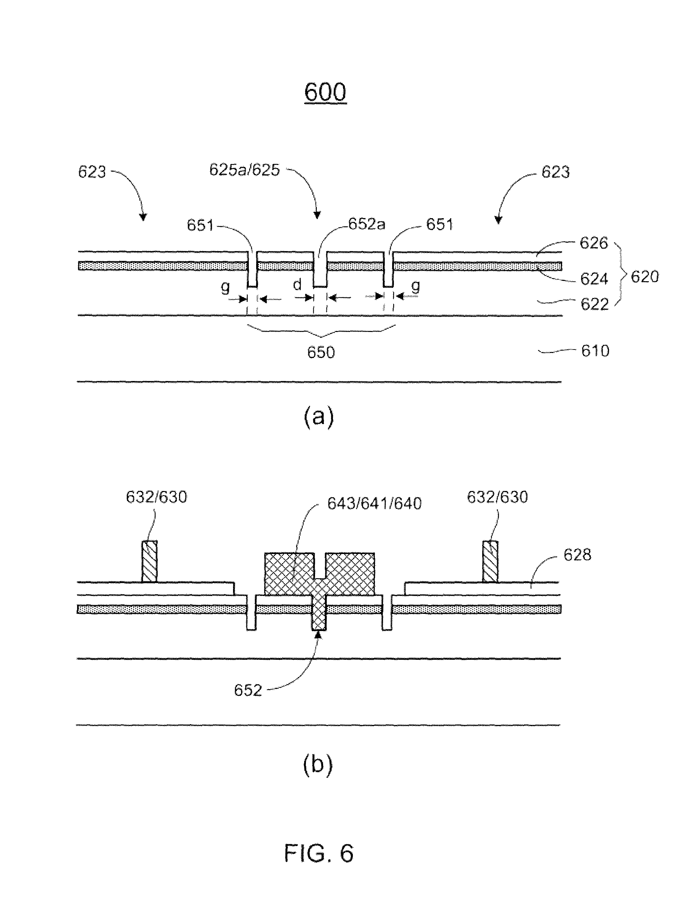

Referring to FIG. 6, a light emitting device 600 is shown according to another embodiment of the present invention. The light emitting device 600 is similar to the light emitting device 100 as shown in FIGS. 1-5. The light emitting device 600 includes a multilayered structure 120 having an n-type semiconductor layer 622 formed on a substrate 610, an active layer 624 formed on the n-type semiconductor layer 622 and a p-type semiconductor layer 626 formed on the active layer 624. In one example, the active layer 624 can be an MQW (Multiple Quantum Well) layer. The light emitting device 600 also includes a transparent conductive layer 628 formed on the p-type semiconductor layer 626. The multilayered structure 120 has a first end portion and an opposite, second end portion defining a light emitting region 623 and a non-emission region 625 therebetween. The non-emission region 625 has a first portion 625a located next to the first end portion and a second portion extending from the first portion into the light emitting region 623.

Instead of an insulator 150 formed in the first portion 125a of the non-emission region 125 of the light emitting device 100, the multilayered structure 620 defines an epitaxial structure 650 in the first portion 625a of the non-emission region 625 of the light emitting device 600. According to the present invention, the epitaxial structure 650 includes at least one layer. As shown in FIG. 6, the epitaxial structure 650 has a p-layer/active layer/n-layer structure, and is isolated from the active layer 624 and the p-type semiconductor layer 626 of the multilayered structure 620. Specifically, the epitaxial structure 650 is spatially isolated from the active layer 624 and the p-type semiconductor layer 626 of the multilayered structure 620 by a gap 651 with a width, g. Further, the epitaxial structure 650 defines one or more grooves 652a to expose the n-type semiconductor layer 622 for providing ohmic contacts.

Additionally, the p-electrode 630 is formed on the transparent conductive layer 628 in the light emitting region 623 and electrically coupled to the p-type semiconductor layer 626 through the transparent conductive layer 628. The n-electrode 640 is formed in the non-emission region 625 and electrically coupled to the n-type semiconductor layer 622. Similarly, the n-electrode 640 has an n-electrode bridge 641 formed on the epitaxial structure 650 in the first portion 625a of the non-emission region 625, and a plurality of n-electrode fingers parallelly formed on the n-type semiconductor layer 640 in the second portion of the non-emission region 625. The n-electrode bridge 641 includes one or more wire connection pads 643 formed on the epitaxial structure 650. Each connection pad 643 is electrically connected to a corresponding n-electrode finger and positioned over the corresponding one ohmic contact 652. Accordingly, the wire connection pad 645 is electrically connected to the n-type semiconductor layer 622 through the ohmic contact 652. The p-electrode 630 has a p-electrode bridge formed proximate to the second end portion of the multilayered structure 620 and a plurality of p-electrode fingers 632 parallelly positioned in the light emitting region 623. The plurality of p-eleetrode fingers 632 and the plurality of n-electrode fingers are alternately arranged.

For such a light emitting device 600, the epitaxial structure 650 is effectively of the insulator 150 of the light emitting device 100 shown in FIGS. 1-5 and functions like a diode. When a current is injected at the p-electrode 630, the current flows from the p-electrode finger 632 along the shortest path (i.e., usually vertically) across the p-n junction to the n-type semiconductor layer 622. The current then spreads laterally within the n-type semiconductor layer 622 to reach the n-electrode 640. Because of the ohmic contact 652 defined on the wire connection pad 643, the current reaching the n-electrode 640 at the area of the wire connection pad 643 is through the ohmic contact 652, which makes the current flowing path from the p-electrode finger 632 to a corresponding n-electrode finger at the area distal to the wire connection pad 643 substantially same as that from the p-electrode finger 632 to the corresponding n-electrode finger at the area of the wire connection pad 643. This results in the uniformity in the current density of the light emitting device 600. Accordingly, the brightness (intensity) of light emitted from the light emitting device is uniform over the light emitting region of the light emitting device 600, as shown in FIG. 7.

As shown in FIGS. 6a and 6b, in one aspect of the present invention, the method of manufacturing the light emitting device 600 includes forming the multilayered structure 620 on the substrate 610, and etching the multilayered structure 620 in the non-emission region 625 to form an epitaxial structure 650 in the first portion 625a of the non-emission region 625 and expose the n-type semiconductor layer 622 in the second portion of the non-emission region 625. The epitaxial structure 650 defines one or more grooves 652a to expose the n-type semiconductor layer 622 for providing ohmic contacts.

The method may include forming the transparent conductive layer 628 on the p-type semiconductor layer 626 in the light emitting region 623. The method further includes forming the n-electrode 640 in the non-emission region 625 such that the n-electrode 640 in the first portion 625a of the non-emission region 625 is electrically coupled to the n-type semiconductor layer 622 through the ohmic contact 652, while the n-electrode 640 in the second portion of the non-emission region 625 is electrically coupled to the n-type semiconductor layer 622 directly. Together with or after the n-electrode 640 is formed, forming a p-electrode 630 on the transparent conductive layer 628 such that the p-electrode 630 is electrically coupled to the p-type semiconductor layer 626 through the transparent conductive layer 628.

In sum, the present invention, among other things, recites a light emitting device having an insulator and/or an epitaxial structure formed under an n-electrode such that a current flowing path between an n-electrode finger and one adjacent p-electrode finger is substantially same as that between the ohmic contact under the wire connection pad and the adjacent p-electrode finger, which results in the uniformity in the current density of the light emitting device. Accordingly, the brightness (intensity) of light emitted from the light emitting device is uniform over the light emitting region of the light emitting device.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to activate others skilled in the art to utilize the invention and various embodiments and with various modifications as are suited to the particular use contemplated. Alternative embodiments will become apparent to those skilled in the art to which the present invention pertains without departing from its spirit and scope. Accordingly, the scope of the present invention is defined by the appended claims rather than the foregoing description and the exemplary embodiments described therein.

## Claims

1. A light emitting device, comprising:
a substrate;
a multilayered structure having a first end portion and an opposite, second end portion defining a light emitting region and a non-emission region therebetween,
the non-emission region having a first portion located next to the first end portion and a second portion extending from the first portion into the light emitting region, the multilayered structure comprising:
an n-type semiconductor layer formed in the light emitting region and the non-emission region on the substrate;
an active layer formed in the light emitting region on the n-type semiconductor layer; and
a p-type semiconductor layer formed in the light emitting region on the active layer;
a p-electrode formed in the light emitting region and electrically coupled to the p-type semiconductor layer;
an n-electrode formed in the non-emission region and electrically coupled to the n-type semiconductor layer; and
an insulator formed between the n-electrode and the n-type semiconductor layer in the first portion of the non-emission region to define at least one ohmic contact such that the n-electrode in the first portion of the non-emission region is electrically coupled to the n-type semiconductor layer through the at least one ohmic contact.

2. The light emitting device of claim 1, wherein the insulator comprises at least one layer, wherein the insulator is formed of a single material or a compound of multiple materials.

3. The light emitting device of claim 2, wherein the insulator is formed of SiO₂, SiN, Al₂O₃, TiO₂, or a combination thereof.

4. The light emitting device of claim 1, wherein the insulator comprises an epitaxial structure.

5. The light emitting device of claim 1,
wherein the n-electrode has an n-electrode bridge formed on the insulator in the first portion of the non-emission region, and a plurality of n-electrode fingers parallelly formed on the n-type semiconductor layer in the second portion of the non-emission region, each n-electrode finger having a first end electrically connected to the n-electrode bridge and an opposite, second end extending to the light emitting region of the multilayered structure;
wherein the p-electrode has a p-electrode bridge formed proximate to the second end portion of the multilayered structure and a plurality of p-electrode fingers parallelly positioned in the light emitting region, each p-electrode finger having a first end electrically connected to the p-electrode bridge, and an opposite, second end extending to the first end portion of the multilayered structure and substantially proximate to the n-electrode bridge; and
wherein the plurality of p-eleetrode fingers and the plurality of n-electrode fingers are alternately arranged.

6. The light emitting device of claim 5, wherein the n-electrode bridge comprises at least one wire connection pad electrically connected to a corresponding n-electrode finger and positioned over the at least one ohmic contact such that the at least one wire connection pad is electrically connected to the n-type semiconductor layer through the at least one ohmic contact.

7. The light emitting device of claim 6, wherein in operation, a current flowing path between the corresponding n-electrode finger and one adjacent p-electrode finger is substantially same as that between the at least one ohmic contact under the at least one wire connection pad and the adjacent p-electrode finger.

8. The light emitting device of claim 1, further comprising a transparent, conductive layer formed on the p-type semiconductor layer in the light emitting region such that the p-electrode is electrically coupled to the p-type semiconductor layer through the transparent conductive layer.

9. A method of manufacturing a light emitting device, comprising the steps of:
providing a substrate;
forming a multilayered structure on the substrate, the multilayered structure comprising:
an n-type semiconductor layer formed on the substrate;
an active layer formed on the n-type semiconductor layer; and
a p-type semiconductor layer formed on the active layer,
the multilayered structure having a first end portion and an opposite, second end portion defining a light emitting region and a non-emission region therebetween, the non-emission region having a first portion located next to the first end portion and a second portion extending from the first portion into the light emitting region;
etching off the p-type the semiconductor layer and the active layer of the multilayered structure in the non-emission region so as to expose the n-type semiconductor layer therein;
forming an insulator in the first portion of the non-emission region on the exposed n-type semiconductor layer, the insulator defining at least one at least one ohmic contact;
forming a transparent, conductive layer on the p-type semiconductor layer in the light emitting region;
forming an n-electrode in the non-emission region such that the n-electrode in the first portion of the non-emission region is electrically coupled to the n-type semiconductor layer through the at least one ohmic contact, and the n-electrode in the second portion of the non-emission region is electrically coupled to the n-type semiconductor layer directly; and
forming a p-electrode on the transparent conductive layer such that the p-electrode is electrically coupled to the p-type semiconductor layer through the transparent conductive layer.

10. The method of claim 9, wherein the p-electrode is formed together with the n-electrode using the same process steps.

11. The method of claim 9, wherein the insulator is formed of a single material or a compound of multiple materials.

12. The method of claim 11, wherein the insulator is formed of at least one of transparent oxides and nitrides.

13. The method of claim 9, wherein the insulator comprises an epitaxial structure.

14. The method of claim 9,
wherein the n-electrode has an n-electrode bridge formed on the insulator in the first portion of the non-emission region, and a plurality of n-electrode fingers parallelly formed on the n-type semiconductor layer in the second portion of the non-emission region, each n-electrode finger having a first end electrical ly connected to the n-electrode bridge and an opposite, second end extending to the light emitting region of the multilayered structure;
wherein the p-electrode has a p-electrode bridge formed proximate to the second end portion of the multilayered structure and a plurality of p-electrode fingers parallelly positioned in the light emitting region, each p-electrode finger having a first end electrically connected to the p-electrode bridge, and an opposite, second end extending to the first end portion of the multilayered structure and substantially proximate to the n-electrode bridge; and
wherein the plurality of p-electrode fingers and the plurality of n-electrode fingers are alternately arranged.

15. The method of claim 14, wherein the n-electrode bridge comprises at least one wire connection pad electrically connected to a corresponding n-electrode finger and positioned over the at least one ohmic contact such that the at least one wire connection pad is electrically connected to the n-type semiconductor layer through the at least one ohmic contact.

16. The method of claim 15, wherein in operation, a current flowing path between the corresponding n-electrode finger and one adjacent p-electrode finger is substantially same as that between the at least one ohmic contact under the at least one wire connection pad and the adjacent p-electrode finger.

17. A light emitting device, comprising:
a substrate;
a multilayered structure having a first end portion and an opposite, second end portion defining a light emitting region and a non-emission region therebetween,
the non-emission region having a first portion located next to the first end portion and a second portion extending from the first portion into the light emitting region, the multilayered structure comprising:
an n-type semiconductor layer formed on the substrate;
an active layer formed on the n-type semiconductor layer; and
a p-type semiconductor layer formed on the active layer,
wherein the multilayered structure is formed to have an multilayered epitaxial structure in the first portion of the non-emission region to define
at least one ohmic contact therein;
an n-electrode formed in the non-emission region and electrically coupled to the n-type semiconductor layer, such that the n-electrode in the first portion of the non-emission region is electrically coupled to the n-type semiconductor layer through at the at least one ohmic contact; and
a p-electrode formed in the light emitting region and electrically coupled to the p-type semiconductor layer.

18. The light emitting device of claim 17, wherein the epitaxial structure comprises a p-layerlactive layer/n-layer structure.

19. The light emitting device of claim 17,
wherein the n-electrode has an n-electrode bridge formed on the insulator in the first portion of the non-emission region, and a plurality of n-electrode fingers parallelly formed on the n-type semiconductor layer in the second portion of the non-emission region, each n-electrode finger having a first end electrically connected to the n-electrode bridge and an opposite, second end extending to the light emitting region of the multilayered structure;
wherein the p-electrode has a p-electrode bridge formed proximate to the second end portion of the multilayered structure and a plurality of p-electrode fingers parallelly positioned in the light emitting region, each p-electrode finger having a first end electrically connected to the p-electrode bridge, and an opposite, second end extending to the first end portion of the multilayered structure and substantially proximate to the n-electrode bridge; and
wherein the plurality of p-electrode fingers and the plurality of n-electrode fingers are alternately arranged.

20. The light emitting device of claim 19, wherein the n-electrode bridge comprises at least one wire connection pad electrically connected to a corresponding n-electrode finger and positioned over the at least one ohmic contact such that the at least one wire connection pad is electrically connected to the n-type semiconductor layer through the at least one ohmic contact.

21. The light emitting device of claim 20, wherein in operation, a current flowing path between the corresponding n-electrode finger and one adjacent p-electrode finger is substantially same as that between the at least one ohmic contact under the at least one wire connection pad and the adjacent p-electrode finger.

22. The light emitting device of claim 17, further comprising a transparent, conductive layer formed on the p-type semiconductor layer in the light emitting region such that the p-electrode is electrically coupled to the p-type semiconductor layer through the transparent conductive layer.
